# EUROPEAN PATENT APPLICATION

(11) **EP 4 550 015 A1**
(43) Date of publication of application: **07.05.2025**
(21) Application number: 24170916.1
(22) Date of filing: 18.04.2024
(51) Int. Cl.: G02B 6/12, G02B 6/122

(54) **PHOTODETECTORS WITH A NOTCHED LIGHT-ABSORBING LAYER**

(30) Priority: 03.11.2023 US 202318501602
(71) Applicant: GlobalFoundries U.S. Inc., Malta, NY 12020 (US)
(72) Inventor: BIAN, Yusheng, Malta, NY, 12020 (US); STRICKER, Andreas D., Essex Junction, VT, 05452 (US); ABOKETAF, Abdelsalam, Essex Junction, VT, 05452 (US); HOLT, Judson R., Malta, NY, 12020 (US); DEZFULIAN, Kevin K., Arlington, VA, 22207 (US); GIEWONT, Kenneth J., Hopewell Junction, NY, 12533 (US); DERRICKSON, Alexander, Malta, NY, 12020 (US); LEE, Won Suk, Malta, NY, 12020 (US); CHANDRAN, Sujith, Malta, NY, 12020 (US); SPORER, Ryan W., Malta, NY, 12020 (US); LIN, Teng-Yin, Malta, NY, 12020 (US)
(74) Representative: Lambacher, Michael

(57) **Abstract**

Structures for a photonics chip that include a photodetector and methods of forming such structures. The structure comprises a photodetector that is disposed on a substrate and that includes a light-absorbing layer. The light-absorbing layer includes a sidewall and a notch in the sidewall. The structure further comprises a waveguide core including a section adjacent to the notch in the sidewall of the light-absorbing layer.

## Description

### BACKGROUND

The disclosure relates to photonics chips and, more specifically, to structures for a photonics chip that include a photodetector and methods of forming such structures.

Photonics chips are used in many applications and systems including, but not limited to, data communication systems and data computation systems. A photonics chip includes a photonic integrated circuit comprised of photonic components, such as modulators, polarizers, and optical couplers, that are used to manipulate light received from a light source, such as an optical fiber or a laser. A photodetector may be employed in the photonic integrated circuit to convert light, which may be modulated as an optical signal, into an electrical signal.

A photodetector may include a light-absorbing layer and a waveguide core that is configured to transfer light to the light-absorbing layer. Photodetectors may suffer from back reflection to the waveguide core that contributes to poor responsivity and quantum efficiency. The back reflection may originate at least in part from index mismatches between the material of the light-absorbing layer of the photodetector and the material of the waveguide core.

Improved structures for a photonics chip that include a photodetector and methods of forming such structures are needed.

### SUMMARY

In an embodiment of the invention, a structure for a photonics chip is provided. The structure comprises a photodetector on a substrate. The photodetector includes a light-absorbing layer, and the light-absorbing layer includes a sidewall and a notch in the sidewall. The structure further comprises a waveguide core including a section adjacent to the notch in the sidewall of the light-absorbing layer.

The section of the first waveguide core may be tapered with a width dimension that increases with decreasing distance from the first sidewall of the light-absorbing layer.

Further, the light-absorbing layer may include a longitudinal axis, and the first notch may be centered along the first sidewall relative to the longitudinal axis. Further, the section of the first waveguide core may include a longitudinal axis that is aligned with the longitudinal axis of the light-absorbing layer; alternatively, the section of the first waveguide core may include a longitudinal axis that is aligned at an acute angle relative to the longitudinal axis of the light-absorbing layer.

Further, the light-absorbing layer may include a longitudinal axis, a second sidewall, and a third sidewall, and the first notch may be positioned between the second sidewall and the third sidewall.

Further, the second sidewall and the third sidewall may be angled at respective acute angles relative to the longitudinal axis.

Further, the second sidewall and the third sidewall may be outwardly curved; alternatively, the second sidewall and the third sidewall may be inwardly curved. Further, the second sidewall may meet the third sidewall at a cusp.

Further, the light-absorbing layer may further include a fourth sidewall, and a second notch in the fourth sidewall; the second notch may be spaced along the longitudinal axis from the first notch, and the structure may further comprise a second waveguide core including a section adjacent to the second notch in the fourth sidewall of the light-absorbing layer.

Further, the section of the first waveguide core may have a longitudinal axis that is aligned with the longitudinal axis of the light-absorbing layer, and the section of the second waveguide core may have a longitudinal axis that is aligned with the longitudinal axis of the light-absorbing layer; alternatively, the section of the first waveguide core may have a longitudinal axis that is aligned at an acute angle relative to the longitudinal axis of the light-absorbing layer, and the section of the second waveguide core may have a longitudinal axis that is aligned at an acute angle relative to the longitudinal axis of the light-absorbing layer.

Further, the structure may further comprise a pad connected to the section of the first waveguide core; a first doped region in the pad, the first doped region having a first conductivity type; and a second doped region in the pad, the second doped region having a second conductivity type opposite to the first conductivity type, wherein the light-absorbing layer may be disposed on a portion of the pad between the first doped region and the second doped region, and the portion of the pad may comprise intrinsic semiconductor material.

Further, the first notch may be a concavity having a second sidewall that is curved.

Further, the first notch may penetrate through a full thickness of the light-absorbing layer.

Further, the first notch may open toward the section of the first waveguide core.

Further, the light-absorbing layer may include a second sidewall and a third sidewall, the first sidewall may include a first portion between the first notch and the second sidewall, and the first sidewall may include a second portion between the first notch and the third sidewall.

Further, the light-absorbing layer may include a first prong between the first notch and the second sidewall, and the light-absorbing layer may include a second prong between the first notch and the third sidewall.

In an embodiment of the invention, a method of forming a structure for a photonics chip is provided. The method comprises forming a photodetector on a substrate. The photodetector includes a light-absorbing layer, and the light-absorbing layer includes a sidewall and a notch in the sidewall. The method further comprises forming a waveguide core including a section adjacent to the notch in the sidewall of the light-absorbing layer.

### BRIEF DESCRIPTION OF THE DRAWINGS

The accompanying drawings, which are incorporated in and constitute a part of this specification, illustrate various embodiments of the invention and, together with a general description of the invention given above and the detailed description of the embodiments given below, serve to explain the embodiments of the invention. In the drawings, like reference numerals refer to like features in the various views.
FIG. 1 is a top view of a structure at an initial fabrication stage of a processing method in accordance with embodiments of the invention.
FIG. 2 is a cross-sectional view taken generally along line 2-2 in FIG. 1.
FIG. 2A is a cross-sectional view taken generally along line 2A-2A in FIG. 1.
FIG. 3 is a top view of the structure at a fabrication stage of the processing method subsequent to FIGS. 1, 2, 2A.
FIG. 4 is a cross-sectional view taken generally along line 4-4 in FIG. 3.
FIG. 4A is a cross-sectional view taken generally along line 4A-4A in FIG. 3.
FIGS. 5, 5A are cross-sectional views of the structure at a fabrication stage of the processing method subsequent to FIGS. 3, 4, 4A.
FIGS. 6, 6A are cross-sectional views of structures in accordance with alternative embodiments of the invention.
FIGS. 7, 7A are top views of structures in accordance with alternative embodiments of the invention.
FIG. 8 is a top view of a structure in accordance with alternative embodiments of the invention.
FIG. 9 is a top view of a structure in accordance with alternative embodiments of the invention.
FIG. 10 is a top view of a structure in accordance with alternative embodiments of the invention.
FIG. 11 is a top view of a structure in accordance with alternative embodiments of the invention.

### DETAILED DESCRIPTION

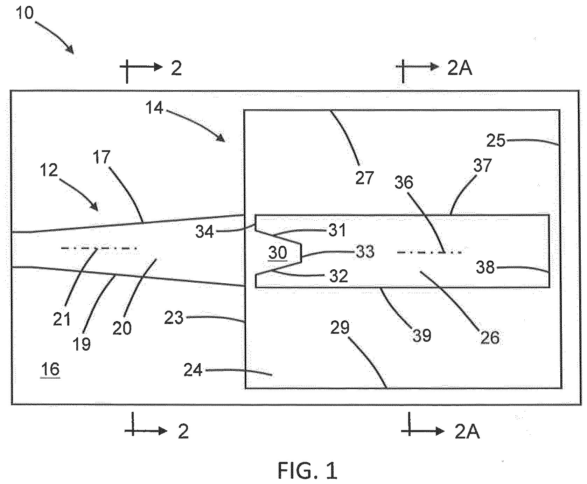

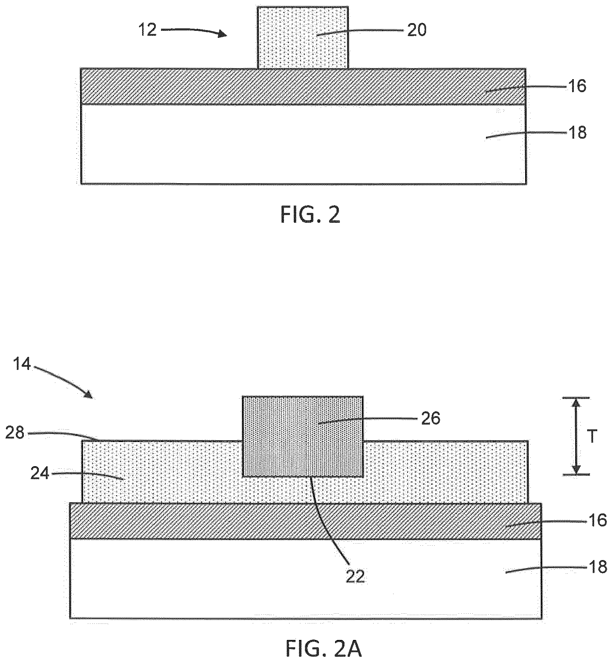

With reference to FIGS. 1, 2, 2A and in accordance with embodiments of the invention, a structure 10 includes a waveguide core 12 and a photodetector 14 are positioned on, and above, a dielectric layer 16 and a semiconductor substrate 18. In an embodiment, the dielectric layer 16 may be comprised of a dielectric material, such as silicon dioxide, and the semiconductor substrate 18 may be comprised of a semiconductor material, such as single-crystal silicon. In an embodiment, the dielectric layer 16 may be a buried oxide layer of a silicon-on-insulator substrate, and the dielectric layer 16 may provide low-index cladding between the waveguide core 12 and the photodetector 14 from the semiconductor substrate 18.

The waveguide core 12 includes a tapered section 20 that is positioned adjacent to the photodetector 14. The tapered section 20, which extends lengthwise along a longitudinal axis 21, has a sidewall 17 and a sidewall 19 opposite from the sidewall 17. The photodetector 14 includes a pad 24 having side edges 23, 25, 27, 29 and a semiconductor layer 26 providing a light-absorbing layer that is disposed on the pad 24 interior of the side edges 23, 25, 27, 29. In an embodiment, the tapered section 20 may be connected to the side edge 23 of the pad 24 such that the sidewalls 17, 19 directly adjoin the side edge 23. In an embodiment, the tapered section 20 may be disposed equidistant from the side edge 27 and the side edge 29. In an embodiment, the semiconductor layer 26 may be disposed equidistant from the side edge 27 and the side edge 29.

The tapered section 20 may have a width dimension that increases with decreasing distance along the longitudinal axis 21 from the side edge 23 of the pad 24. In an embodiment, the width dimension of the tapered section 20 may increase linearly with decreasing distance from the side edge 23. In an alternative embodiment, the width dimension of the tapered section 20 may vary based on a non-linear function, such as a quadratic function, a cubic function, a parabolic function, a sine function, a cosine function, a Bezier function, or an exponential function. In an embodiment, the tapered section 20 may include a single stage of tapering characterized by a taper angle. In an alternative embodiment, the tapered section 20 may taper in multiple stages each characterized by a different taper angle.

In an alternative embodiment, the tapered section 20 of the waveguide core 12 may be tapered in the height dimension as well as tapered in the width dimension. For example, the height dimension of the tapered section 20 may increase with decreasing distance from the side edge 23 of the pad 24. In an alternative embodiment, the semiconductor substrate 18 may include a cavity or undercut beneath all or part of the tapered section 20 of the waveguide core 12.

In an embodiment, the waveguide core 12 and the pad 24 of the photodetector 14 may be comprised of a material having a refractive index that is greater than the refractive index of silicon dioxide. In an embodiment, the waveguide core 12 and the pad 24 of the photodetector 14 may be comprised of a semiconductor material. In an embodiment, the waveguide core 12 and the pad 24 of the photodetector 14 may be comprised of single-crystal silicon. The waveguide core 12 and the pad 24 of the photodetector 14 may be formed by patterning a layer comprised of their constituent material with lithography and etching processes. In an embodiment, the waveguide core 12 and the pad 24 of the photodetector 14 may be formed by patterning the semiconductor material (e.g., single-crystal silicon) of a device layer of a silicon-on-insulator substrate. In an embodiment, the tapered section 20 of the waveguide core 12 may be included in a stacked waveguide that includes, for example, a tapered section of another waveguide core comprised of a different material, such as polysilicon or silicon nitride, that is disposed in a level elevated above the tapered section 20.

The semiconductor layer 26 of the photodetector 14 may be comprised of a light-absorbing material that generates charge carriers from photons of absorbed light by photoelectric conversion. In an embodiment, the semiconductor layer 26 may be comprised of an intrinsic semiconductor material. In an embodiment, the semiconductor layer 26 may be comprised of intrinsic germanium. In an embodiment, the semiconductor layer 26 may be comprised of an intrinsic semiconductor material having a composition that includes germanium. In an alternative embodiment, the semiconductor layer 26 may be comprised of a different type of semiconductor material, such as a III-V compound semiconductor material or silicon.

The semiconductor layer 26 may be formed by an epitaxial growth process. In an embodiment, the semiconductor layer 26 may be epitaxially grown inside a trench 22 that is patterned in the pad 24 such that the semiconductor layer 26 includes a lower portion disposed below a top surface 28 of the pad 24 and an upper portion disposed above the top surface 28 of the pad 24. A hardmask comprised of a dielectric material may be disposed on the top surface 28 of the pad 24 and surround the trench 22 during the epitaxial growth process and may be removed following the epitaxial growth process. The shape of the upper portion of the semiconductor layer 26, from a vertical perspective, may conform to the outline of the trench 22 that is patterned in the pad 24.

The semiconductor layer 26 has an end portion that includes a notch 30 representing an indentation that extends into a sidewall 34 of the semiconductor layer 26. The notch 30 is disposed adjacent to the tapered section 20 of the waveguide core 12 and the side edge 23 of the pad 24, and the notch 30 opens toward the tapered section 20 of the waveguide core 12. The notch 30 is disposed over an area of the pad 24 from which the light-absorbing material of the semiconductor layer 26 is absent. The end portion of the semiconductor layer 26 includes sidewalls 31, 32, 33 that surround the notch 30 and the area of the pad 24 inside the boundary of the notch 30 on multiple sides. In an embodiment, the sidewalls 31, 32, 33 may intersect at sharp corners. In an embodiment, the sidewalls 31, 32, 33 may intersect at rounded or radiused corners. In an embodiment, the sidewalls 31, 32, 33 may be planar and may intersect at sharp corners. In an embodiment, the sidewalls 31, 32, 33 may be planar and may intersect at rounded or radiused corners.

The semiconductor layer 26 extends lengthwise on the pad 24 along a longitudinal axis 36. The sidewall 31 is slanted at an acute angle relative to the longitudinal axis 36 of the semiconductor layer 26. The sidewall 32 is also slanted at an acute angle relative to the longitudinal axis 36 of the semiconductor layer 26. In an embodiment, the acute angles of the sidewalls 31, 32 may be equal. The sidewall 33 may connect the sidewall 31 to the sidewall 32. In an embodiment, the sidewall 33 may be oriented transverse to the longitudinal axis 36.

The semiconductor layer 26 may also have a sidewall 37 that is positioned adjacent to the side edge 27 of the pad 24, a sidewall 38 that is positioned adjacent to the side edge 25 of the pad 24, and a sidewall 39 that is positioned adjacent to the side edge 29 of the pad 24. The semiconductor layer 26 includes a prong that is disposed between the sidewall 31 and an adjacent portion of the sidewall 37, and that is terminated by a portion of the sidewall 34 adjacent to the tapered section 20 of the waveguide core 12. The semiconductor layer 26 includes another prong that is disposed between the sidewall 32 and an adjacent portion of the sidewall 39, and that that is terminated by another portion of the sidewall 34 adjacent to the tapered section 20 of the waveguide core 12. In an embodiment, the sidewall 34 may be bifurcated to provide the portions that terminate the prongs separated by the notch 30. In an embodiment, the portions of the sidewall 34 terminating the prongs may be planar. In an alternative embodiment, the portions of the sidewall 34 terminating the prongs may be rounded or radiused. In an alternative embodiment, the sidewall 31 may intersect the sidewall 37 at a point and the sidewall 32 may intersect the sidewall 39 at a point such that the prongs are triangular instead of trapezoidal and the sidewall 34 is absent.

The sidewalls 31, 32, 33 adjacent to the notch 30 and the portions of the sidewall 34 at the tips or ends of the prongs may be considered to define a facet of the semiconductor layer 26 of the photodetector 14. The facet is configured to receive light from the tapered section 20 of the waveguide core 12. In an embodiment, the longitudinal axis 36 of the semiconductor layer 26 may be aligned parallel to the longitudinal axis 21 of the tapered section 20. In an alternative embodiment, the longitudinal axis 21 of the tapered section 20 may be angled relative to the longitudinal axis 36 of the semiconductor layer 26. In an embodiment, the notch 30 may be symmetrical and centered about the longitudinal axis 36 such that the notch 30 has a symmetrical placement in the semiconductor layer 26.

In an embodiment, the notch 30 may extend through the full thickness T of the semiconductor layer 26. In an alternative embodiment, the semiconductor layer 26 may be formed on the top surface 28 of the pad 24, instead of inside the trench 22, such that the full thickness T of the semiconductor layer 26 is disposed above the top surface 28. In this regard, the semiconductor layer 26 may be epitaxially grown on the top surface 28 of the pad 24 and then patterned by lithography and etching processes to shape and to form the notch 30.

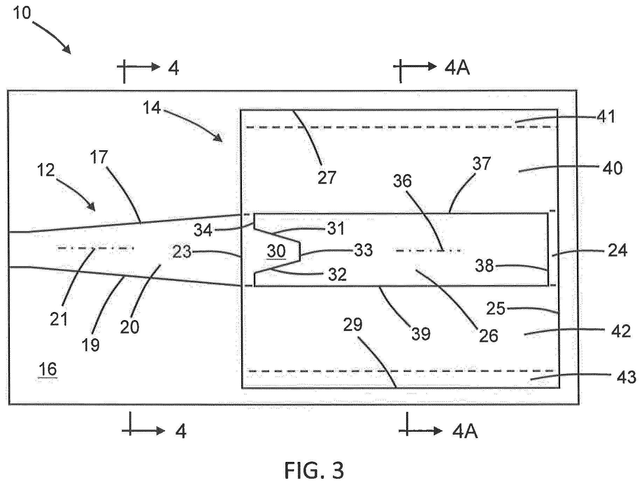

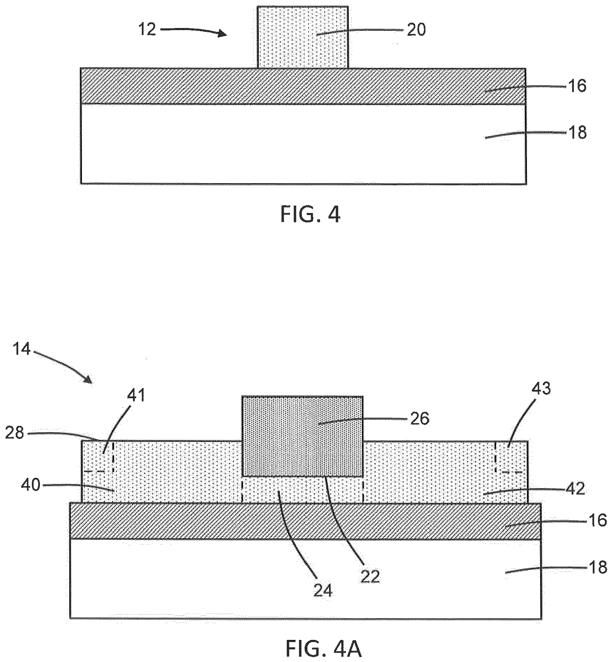

With reference to FIGS. 3, 4, 4A in which like reference numerals refer to like features in FIGS. 1, 2, 2A and at a subsequent fabrication stage, the structure 10 may include a doped region 40 formed in a portion of the pad 24 adjacent to the sidewall 37 of the semiconductor layer 26 and a doped region 42 that is formed in a portion of the pad 24 adjacent to the sidewall 39 of the semiconductor layer 26. The semiconductor layer 26 is laterally positioned between the doped region 40 and the doped region 42. The doped regions 40, 42, which differ in conductivity type, may extend fully through the entire thickness of the pad 24 to the underlying dielectric layer 16. The doped region 40 and the doped region 42 may respectively define an anode and a cathode of the photodetector 14.

The doped region 40 may be formed by, for example, ion implantation with an implantation mask having an opening that determines the implanted area of the pad 24. The implantation mask may include a layer of photoresist applied by a spin-coating process, prebaked, exposed to light projected through a photomask, baked after exposure, and developed with a chemical developer to define the opening over the area of the pad 24 to be implanted. The implantation conditions, such as ion species, dose, and kinetic energy, may be selected to tune the electrical and physical characteristics of the doped region 40. The implantation mask may be stripped after forming the doped region 40. In an embodiment, the semiconductor material of the doped region 40 may contain a p-type dopant, such as boron, that provides p-type electrical conductivity. In an alternative embodiment, a portion of the semiconductor layer 26 immediately adjacent to the doped region 40 and an underlying portion of the pad 24 may be implanted with the p-type dopant due to overlap of the opening in the implantation mask.

The doped region 42 may be formed by, for example, ion implantation with an implantation mask having an opening that determines an implanted area of the pad 24. The implantation mask may include a layer of photoresist applied by a spin-coating process, prebaked, exposed to light projected through a photomask, baked after exposure, and developed with a chemical developer to define the opening over the area of the pad 24 to be implanted. The implantation conditions, such as ion species, dose, and kinetic energy, may be selected to tune the electrical and physical characteristics of the doped region 42. The implantation mask may be stripped after forming the doped region 42. In an embodiment, the semiconductor material of the doped region 42 may contain an n-type dopant, such as phosphorus or arsenic, that provides n-type electrical conductivity. In an alternative embodiment, a portion of the semiconductor layer 26 immediately adjacent to the doped region 42 and an underlying portion of the pad 24 may be implanted with the n-type dopant due to overlap of the opening in the implantation mask.

A portion of the pad 24 beneath the semiconductor layer 26 may be comprised of intrinsic semiconductor material, such as intrinsic silicon, that is not doped by the ion implantations forming the doped regions 40, 42. The longitudinal axis 21 of the tapered section 20 may intersect the intrinsic portion of the pad 24. In an embodiment, the intrinsic portion of the pad 24 may extend from the side edge 23 of the pad 24 to the side edge 25 of the pad 24. The doped region 40, the intrinsic semiconductor materials of the semiconductor layer 26 and the portion of the pad 24 beneath the semiconductor layer 26, and the doped region 42 may define a lateral p-i-n diode structure that enables the functionality of the photodetector 14.

A heavily-doped region 41 may be formed by a masked ion implantation in a portion of the doped region 40 adjacent to the side edge 27, and a heavily-doped region 43 may be formed by a masked ion implantation in a portion of the doped region 42 adjacent to the side edge 29. The heavily-doped region 41 may be doped with the same conductivity type as the doped region 40 but at a higher dopant concentration. The heavily-doped region 43 may be doped with the same conductivity type as the doped region 42 but at a higher dopant concentration.

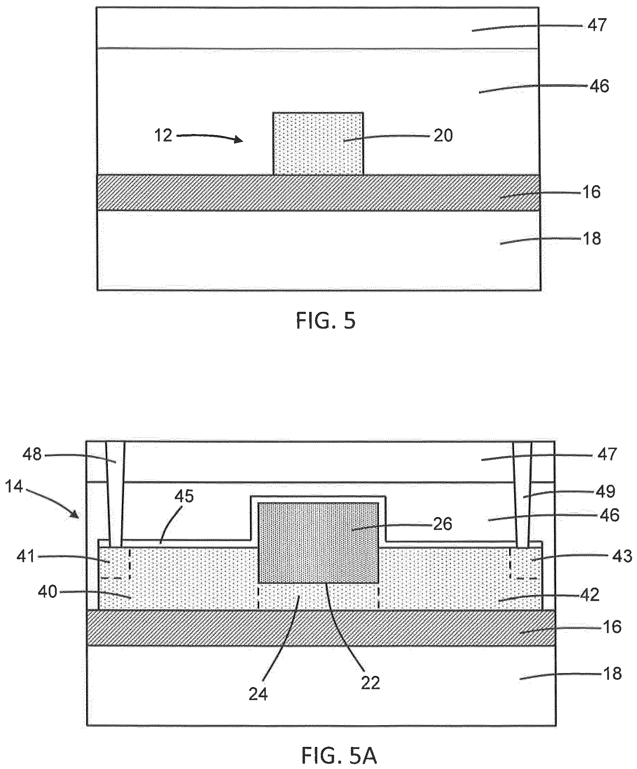

With reference to FIGS. 5, 5A in which like reference numerals refer to like features in FIGS. 3, 4, 4A and at a subsequent fabrication stage, a conformal dielectric layer 45 may be formed that extends across the pad 24 and semiconductor layer 26 and that follows the topography created by the semiconductor layer 26. The conformal dielectric layer 45 may be comprised of a dielectric material, such as silicon nitride. An additional conformal dielectric layer (not shown) comprised of a dielectric material, such as silicon dioxide, may be disposed between the semiconductor layer 26 and the conformal dielectric layer 45.

Dielectric layers 46, 47 are formed on the waveguide core 12 and the photodetector 14. In an embodiment, the dielectric layers 46, 47 may be comprised of a dielectric material, such as silicon dioxide, that has a lower refractive index than the material of the waveguide core 12. The dielectric layer 46 may be deposited and planarized, and the dielectric layer 47 may be deposited on the planarized dielectric layer 46.

Contacts 48 may be formed that penetrate fully through the conformal dielectric layer 45 and the dielectric layers 46, 47 to land on the heavily-doped region 41, and contacts 49 may be formed that penetrate fully through the conformal dielectric layer 45 and the dielectric layers 46, 47 to land on the heavily-doped region 43. The heavily-doped region 41 electrically couples the contacts 48 to the doped region 40 with a reduced contact resistance. The heavily-doped region 43 electrically couples the contacts 49 to the doped region 42 with a reduced contact resistance. The contacts 48, 49 may be comprised of a metal, such as tungsten. The doped regions 40, 42 may be biased through the contacts 48, 49, which may be coupled to interconnects (not shown) in dielectric layers formed over the dielectric layer 47.

In use, light, such as laser light, propagates in the waveguide core 12 toward the photodetector 14 and is coupled from the tapered section 20 of the waveguide core 12 to the semiconductor layer 26 of the photodetector 14. The waveguide core 12 may support propagation of light with transverse-electric polarization, transverse-magnetic polarization, or a combination of both polarizations. In an embodiment, the light received by the photodetector 14 may be modulated as an optical signal. The semiconductor layer 26 absorbs photons of the light and converts the absorbed photons into charge carriers by photoelectric conversion. The biasing of the doped regions 40, 42 causes the charge carriers to be collected and output to provide, as a function of time, a measurable photocurrent.

The notch 30 formed in the semiconductor layer 26 may function to significantly reduce optical reflection loss and insertion loss while maintaining a high coupling efficiency and without introducing a loss of responsivity for the embodiments of the photodetector 14. The benefits associated with the embodiments of the photodetector 14 may be particularly advantageous for optical transceivers targeted for use in optical interconnects that transfer modulated light as data through an optical fiber over a significant distance between different locations. For example, such optical transceivers may be deployed in a data communication system or a data computation system.

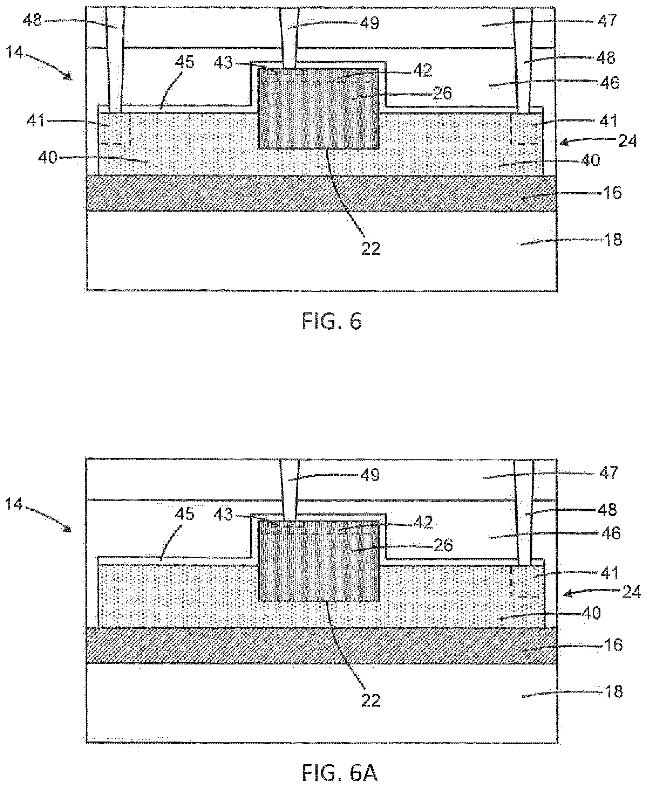

With reference to FIGS. 6, 6A and in accordance with alternative embodiments, the structure 10 may be modified such that the photodetector 14 has a vertical arrangement instead of a lateral arrangement. Specifically, as shown in FIG. 6, the doped region 40 may be extend across the entire pad 24, heavily-doped regions 41 may be disposed in the pad 24 on both sides of the semiconductor layer 26, and the doped region 42 and heavily-doped region 43 may be disposed in an upper portion of the semiconductor layer 26. In an alternative embodiment and as shown in FIG. 6A, the structure 10 may be configured with a heavily-doped region 41 disposed in the pad 24 adjacent to only one side of the semiconductor layer 26.

In an alternative embodiment, the semiconductor layer 26 may be fully disposed on, and above, the top surface 28 of the pad 24. In an alternative embodiment, the photodetector 14 may be configured as an avalanche photodetector that includes a region of intrinsic semiconductor material in the pad 24 defining a multiplication region and an additional doped region in the pad 24 defining a charge control region.

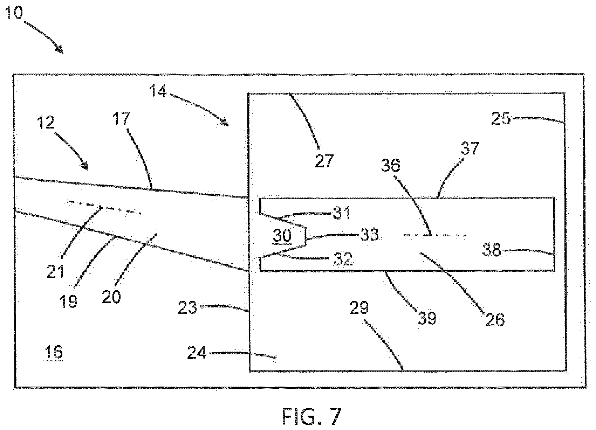

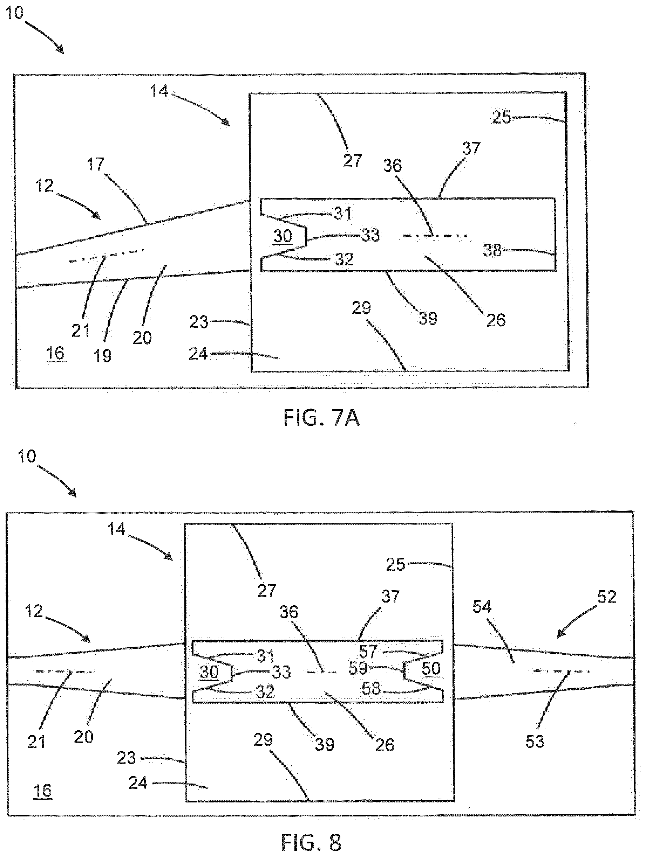

With reference to FIGS. 7, 7A and in accordance with alternative embodiments, the longitudinal axis 21 of the tapered section 20 may be slanted relative to the side edge 23 of the pad 24 and the longitudinal axis 36 of the semiconductor layer 26 in order to further reduce the optical return loss. In an embodiment, the longitudinal axis 36 of the semiconductor layer 26 may be oriented at an acute tilt angle relative to the longitudinal axis 21 of the tapered section 20. In an embodiment and as shown in FIG. 7, the longitudinal axis 21 of tapered section 20 may be oriented to form a positive angular differential between the longitudinal axis 21 and the longitudinal axis 36. In an embodiment and as shown in FIG. 7A, the tapered section 20 may be oriented to form a negative angular differential between the longitudinal axis 21 and the longitudinal axis 36.

With reference to FIG. 8 and in accordance with alternative embodiments, the semiconductor layer 26 may be modified to include a notch 50 in an end portion that is longitudinally disposed at an opposite end of the semiconductor layer 26 from the end portion including the notch 30. The notch 50 may be surrounded on multiple sides by sidewalls 57, 58, 59 that are similar to the sidewalls 31, 32, 33. The notch 50 is positioned adjacent to the side edge 25 of the pad 24 and is inset as an indentation into the sidewall 38 (FIG. 7) of the semiconductor layer 26. In an embodiment, the sidewall 38 may be bifurcated to provide portions that terminate respective prongs of the semiconductor layer 26 separated by the notch 50.

The structure 10 may also include a waveguide core 52 having a tapered section 54 that is positioned adjacent to the side edge 25 of the pad 24 and opposite from tapered section 20 of the waveguide core 12 adjacent to the side edge 23. The tapered section 54 of the waveguide core 52 is positioned adjacent to the notch 50 in the semiconductor layer 26. In an embodiment, the side edge 25 of the pad 24 may be positioned between the tapered section 54 of the waveguide core 52 and the notch 50 in the semiconductor layer 26. The tapered section 54 of the waveguide core 52 may be similar or identical to the tapered section 20 of the waveguide core 12. In an embodiment, the waveguide core 52 may be comprised of the same material as the waveguide core 12 and the pad 24. The sidewalls 57, 58, 59 surrounding the notch 50 and the remaining portions of the sidewall 38 define a facet of the semiconductor layer 26 of the photodetector 14, and the facet is configured to receive light from the tapered section 54 of the waveguide core 52. In an alternative embodiment, the longitudinal axis 21 of the tapered section 20 of the waveguide core 12 and/or a longitudinal axis 53 of the tapered section 54 of the waveguide core 52 may be angled as shown in either FIG. 7 or FIG. 7A.

The tapered section 54 of the waveguide core 52 may supply another input to the photodetector 14 in addition to the input provided by the tapered section 20 of the waveguide core 12. The total optical power delivered to the photodetector 14 may be split between the input provided by the tapered section 20 and the input provided by the tapered section 54. The notch 50 in the semiconductor layer 26 may significantly reduce optical reflection loss while maintaining a high coupling efficiency and without introducing a loss of responsivity for the photodetector 14.

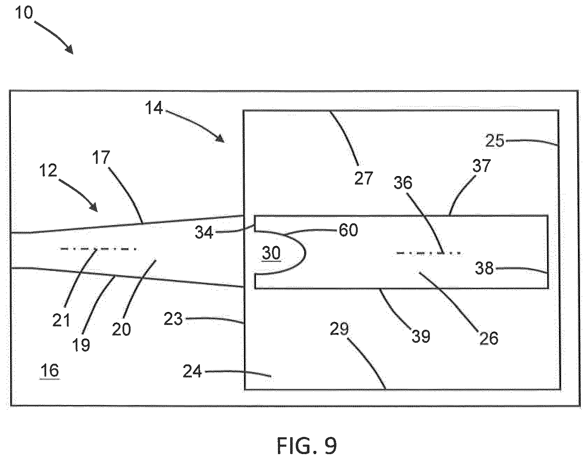

With reference to FIG. 9 and in accordance with embodiments of the invention, the notch 30 may be configured as a concavity surrounded by a curved sidewall 60 instead of a polygon surrounded by planar sidewalls 31, 32, 33 (FIG. 1). The curved sidewall 60 may be characterized by a concave shape that is inwardly curved and that opens toward the tapered section 20 of the waveguide core 12.

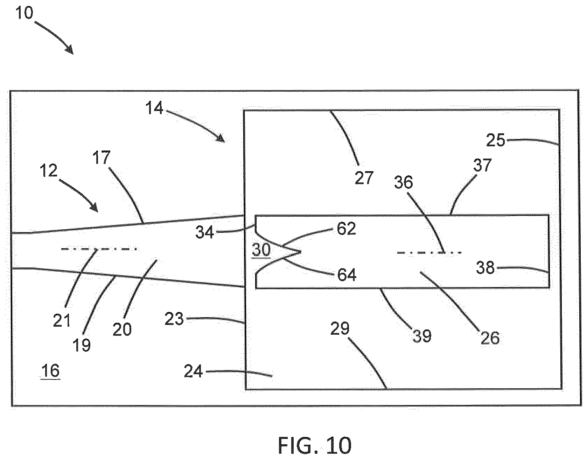

With reference to FIG. 10 and in accordance with embodiments of the invention, the notch 30 may be configured as a cusped shape surrounded by curved sidewalls 62, 64 instead of a polygon surrounded by planar sidewalls 31, 32, 33 (FIG. 1). The curved sidewalls 62, 64 may be characterized by respective convex shapes that are outwardly curved and that intersect at a cusp to form the cusped shape, which opens toward the tapered section 20 of the waveguide core 12.

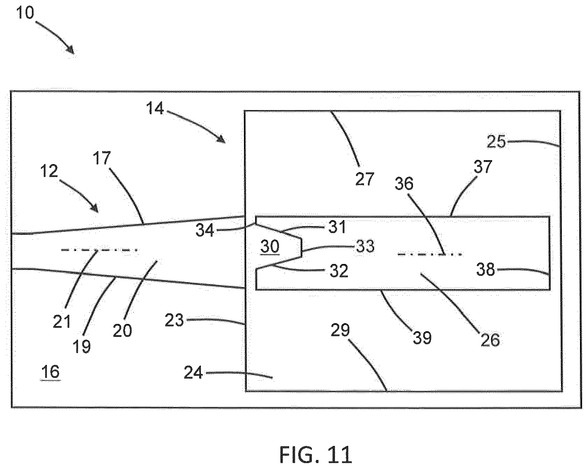

With reference to FIG. 11 and in accordance with embodiments of the invention, the notch 30 may be laterally offset relative to the longitudinal axis 36 of the semiconductor layer 26 such that the notch 30 is asymmetrically disposed in the semiconductor layer 26. The width dimensions of the portions of the sidewall 34 terminating the prongs of the semiconductor layer 26 adjacent to the notch 30 may differ as a result of the lateral offset.

The methods as described above are used in the fabrication of integrated circuit chips. The resulting integrated circuit chips can be distributed by the fabricator in raw wafer form (e.g., as a single wafer that has multiple unpackaged chips), as a bare die, or in a packaged form. The chip may be integrated with other chips, discrete circuit elements, and/or other signal processing devices as part of either an intermediate product or an end product. The end product can be any product that includes integrated circuit chips, such as computer products having a central processor or smartphones.

References herein to terms modified by language of approximation, such as "about", "approximately", and "substantially", are not to be limited to the precise value specified. The language of approximation may correspond to the precision of an instrument used to measure the value and, unless otherwise dependent on the precision of the instrument, may indicate a range of +/- 10% of the stated value(s).

References herein to terms such as "vertical", "horizontal", etc. are made by way of example, and not by way of limitation, to establish a frame of reference. The term "horizontal" as used herein is defined as a plane parallel to a conventional plane of a semiconductor substrate, regardless of its actual three-dimensional spatial orientation. The terms "vertical" and "normal" refer to a direction in the frame of reference perpendicular to the horizontal, as just defined. The term "lateral" refers to a direction in the frame of reference within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or in "direct contact" with another feature if intervening features are absent. A feature may be "indirectly on" or in "indirect contact" with another feature if at least one intervening feature is present. Different features "overlap" if a feature extends over, and covers a part of, another feature.

The descriptions of the various embodiments of the present invention have been presented for purposes of illustration but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure for a photonics chip, the structure comprising:
a substrate;
a photodetector on the substrate, the photodetector including a light-absorbing layer, and the light-absorbing layer including a first sidewall and a first notch in the first sidewall; and
a first waveguide core including a section adjacent to the first notch in the first sidewall of the light-absorbing layer.

2. The structure of claim 1 wherein the section of the first waveguide core is tapered with a width dimension that increases with decreasing distance from the first sidewall of the light-absorbing layer.

3. The structure of claim 1 or claim 2 wherein the light-absorbing layer includes a longitudinal axis, and the first notch is centered along the first sidewall relative to the longitudinal axis.

4. The structure of one of claims 1 to 3 wherein the light-absorbing layer includes a longitudinal axis, and the section of the first waveguide core includes a longitudinal axis that is aligned with the longitudinal axis of the light-absorbing layer, or wherein the light-absorbing layer includes a longitudinal axis, and the section of the first waveguide core includes a longitudinal axis that is aligned at an acute angle relative to the longitudinal axis of the light-absorbing layer.

5. The structure of one of claims 1 to 4 wherein the light-absorbing layer includes a longitudinal axis, a second sidewall, and a third sidewall, and the first notch is positioned between the second sidewall and the third sidewall.

6. The structure of claim 5 wherein the second sidewall and the third sidewall are angled at respective acute angles relative to the longitudinal axis.

7. The structure of claim 6 wherein the second sidewall and the third sidewall are outwardly curved, or wherein the second sidewall and the third sidewall are inwardly curved.

8. The structure of claim 7 wherein the second sidewall meets the third sidewall at a cusp.

9. The structure of one of claims 1 to 8 wherein the light-absorbing layer includes a longitudinal axis, a fourth sidewall, and a second notch in the fourth sidewall, the second notch is spaced along the longitudinal axis from the first notch, and further comprising:
a second waveguide core including a section adjacent to the second notch in the fourth sidewall of the light-absorbing layer.

10. The structure of claim 9 wherein the section of the first waveguide core has a longitudinal axis that is aligned with the longitudinal axis of the light-absorbing layer, and the section of the second waveguide core has a longitudinal axis that is aligned with the longitudinal axis of the light-absorbing layer, or wherein the section of the first waveguide core has a longitudinal axis that is aligned at an acute angle relative to the longitudinal axis of the light-absorbing layer, and the section of the second waveguide core has a longitudinal axis that is aligned at an acute angle relative to the longitudinal axis of the light-absorbing layer.

11. The structure of one of claims 1 to 10 further comprising:
a pad connected to the section of the first waveguide core;
a first doped region in the pad, the first doped region having a first conductivity type; and
a second doped region in the pad, the second doped region having a second conductivity type opposite to the first conductivity type,
wherein the light-absorbing layer is disposed on a portion of the pad between the first doped region and the second doped region, and the portion of the pad comprises intrinsic semiconductor material.

12. The structure of one of claims 1 to 11 wherein the first notch is a concavity having a second sidewall that is curved, and/or wherein the first notch penetrates through a full thickness of the light-absorbing layer, and/or wherein the first notch opens toward the section of the first waveguide core.

13. The structure of one of claims 1 to 12 wherein the light-absorbing layer includes a second sidewall and a third sidewall, the first sidewall includes a first portion between the first notch and the second sidewall, and the first sidewall includes a second portion between the first notch and the third sidewall.

14. The structure of claim 13 wherein the light-absorbing layer includes a first prong between the first notch and the second sidewall, and the light-absorbing layer includes a second prong between the first notch and the third sidewall.

15. A method of forming a structure for a photonics chip, the method comprising:
forming a photodetector on a substrate, wherein the photodetector includes a light-absorbing layer, and the light-absorbing layer includes a sidewall and a notch in the sidewall; and
forming a waveguide core including a section adjacent to the notch in the sidewall of the light-absorbing layer.
